# EUROPEAN PATENT SPECIFICATION

(11) **EP 0 903 937 B1**
(45) Date of publication and mention of the grant of the patent: **11.02.2004**
(21) Application number: 98307098.8
(22) Date of filing: 03.09.1998
(51) Int. Cl.: H04N 5/44

(54) **Digital television signal receiving tuner system**
Abstimmsystem für den Empfang von digitalen Fernsehsignalen
Système de syntonisation récepteur d'un signal de télévision numérique

(30) Priority: 22.09.1997 JP 25734597
(43) Date of publication of application: 24.03.1999
(73) Proprietor: ALPS ELECTRIC CO., LTD., Ota-ku Tokyo 145 (JP)
(72) Inventor: Takayama, Akira, Soma-shi, Fukushima-ken (JP); Tadachi, Akio, Soma-shi, Fukushima-ken (JP); Tanaka, Ryoichi, Soma-shi, Fukushima-ken (JP)
(74) Representative: Kensett, John Hinton

(56) References cited:
- EP-A- 0 769 873
- US-A- 5 636 252
- EILERS C.: 'NTSC TV receiver performance with upper adjacent channel ATV interference' IEEE TRANSACTIONS ON CONSUMER ELECTRONICS vol. 42, no. 3, August 1996, pages 710 - 715
- PETKE G.: 'Planungsaspekte für digitales terrestrisches Fernsehen' RUNDFUNKTECHNISCHE MITTEILUNGEN vol. 37, no. 3, May 1993 - June 1993, NORDERSTEDT,DE, pages 119 - 129

## Description

The present invention relates to a tuner system that receives digital television signals transmitted via ground waves.

In digital television broadcasting, satellite broadcasting and cable television (CATV) broadcasting have already been put into practical use, and ground broadcasting is also being planned for practical use. Digital television broadcasting methods vary among countries and regions, and the Orthogonal Frequency Division Multiplex (OFDM) method is employed in Europe and Japan. In the OFDM method, a few thousands of carrier waves are provided for the broadcasting band of each channel of a conventionally used ground television system and are modulated with, for example, a baseband signal according to the Quadriphase Phase Shift Keying (QPSK) method and then transmitted.

In the OFDM digital television system, broadcasting frequency bands allocated to conventionally used analog television broadcasting are used, and thus, channels in which digital television signals are transmitted are located adjacent to channels in which analog television signals are transmitted.

Accordingly, analog television signals may be mixed with digital television signals. In this state, digital television signals may interfere with an analog television receiver. To avoid this situation, in compliance with the broadcasting standards, the level of digital television signals is reduced by an amount in the range of 20 dB to 35 dB relative to that of analog television signals before they are transmitted. A receiver of digital television signals that sufficiently receives signals of levels from -96 dBm to -20 dBm at its receiving input terminal without any trouble is also demanded. The signal level receivable by a digital television signal receiver is thus required to have a dynamic range as wide as 76 dB.

As discussed above, digital television signals may be transmitted with analog television signals, for example, channels in which digital television signals are transmitted are located adjacent to those in which analog television signals are transmitted. In this case, analog television signals may disadvantageously interfere with a digital television signal receiver.

In response to a wide dynamic range of digital television signals, such as 76 dB, a digital television signal receiver is required to have a wide gain control range and also to suppress distortion caused by gain control.

Accordingly, it is an object of the present invention to eliminate interference of analog television signals upon receiving a digital television signal and to suppress the generation of distortion even in a wide gain control range.

In order to achieve the above object, according to the present invention, there is provided a digital television signal receiving tuner system in accordance with independent claim 1.

US-A-5 636 252 discloses a digital TV receiver using the known superheterodyne principle which involves the mixing of the wanted input frequency to intermediate frequencies (IF). The IFs are filtered and amplified in accordance with HDTV specifications using automatic gain control circuitry.

The article "Planungsaspekte für digitales terrestrisches Femsehen" by G. Petke (published in Rundfunktechnische Mitteilungen, Mensing, Norderstedt, DE, May 1993) presents issues about of the coexistence of digital and analog TV signals on adjacent channels and addresses carrier-to-interference requirements.

The article "NTSC TV Receiver Performance with upper adjacent channel ATV interference" by C. Eilers (published in IEEE Transactions on Consumer Electronics, IEEE INC., New York, August 1996) shows the use and the characteristics of SAW filters in order to reject adjacent channel interference.

Embodiments of the invention will now be described, by way of example only, with reference to the accompanying drawings, in which:
Fig. 1 is a block diagram illustrating a digital television signal receiving tuner system according to the present invention;
Fig. 2 is a characteristic diagram illustrating adjacent-channel attenuation means for use in a digital television signal receiving tuner system according to the present invention;
Fig. 3 is a circuit diagram illustrating adjacent-channel attenuation means for use in a digital television signal receiving tuner system according to the present invention; and
Fig. 4 illustrates a modification made to the adjacent-channel attenuation means for use in a digital television signal receiving tuner system according to the present invention.

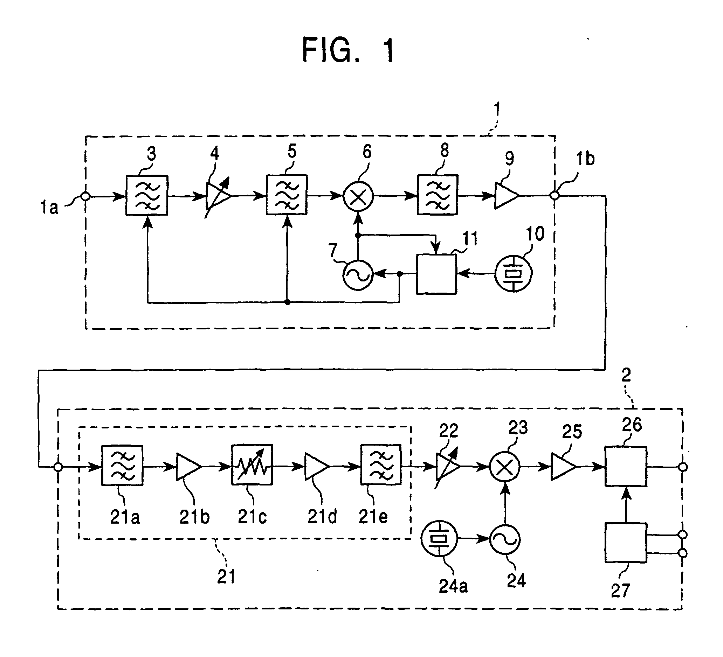

A digital television signal receiving tuner system of the present invention is now described with reference to Fig. 1.

In the following description, digital television signals and analog television signals are simply referred to as "television signals" unless they are required to be distinguished.

A digital television signal receiving tuner system of the present invention is formed of a tuner 1 and an intermediate frequency circuit 2. The tuner 1, as well as a tuner for receiving analog television signals, has an input tuning circuit 3, a high frequency amplifier 4, an interstage tuning circuit 5, a first mixer 6, a first local oscillator 7, an intermediate frequency tuning circuit 8, and an intermediate frequency amplifier 9. The high frequency amplifier 4 is formed of a first variable-gain amplifier in which the gain is controlled in accordance with a control voltage from an automatic gain voltage generating circuit (not shown).

For convenience, the input tuning circuit 3, the high frequency amplifier 4, the interstage tuning circuit 5, and the first mixer 6 are indicated by one system. In practice, however, two systems used for VHF television signals and UHF television signals are provided for the tuner.

A television signal is input into a tuner input terminal 1a, and a desired channel of the television signal is selected and amplified in the input tuning circuit 3, the high frequency amplifier 4, and the interstage tuning circuit 5. The amplified television signal is then input into the first mixer 6 in which it is mixed with a local oscillation signal output from the first local oscillator 7 and is converted into a first intermediate frequency signal (approximately 36 MHz in the Europe television system). The first intermediate frequency signal passes through the intermediate frequency tuning circuit 8 and the intermediate frequency amplifier 9 and is output from a tuner output terminal 1b.

Not only digital television signals, but also analog television signals are input into the tuner input terminal 1a. Accordingly, only a desired digital television signal is selected by the input tuning circuit 3 and the interstage tuning circuit 5 and is converted into a first intermediate frequency signal by being mixed with a local oscillation signal. Thus, the oscillation frequency of the local oscillator 7 is controlled by a PLL circuit 11 provided with a reference oscillator 10. The PLL circuit 11 is provided with a tuning voltage generating circuit (not shown) for controlling the tuning frequency of the input tuning circuit 3 and the interstage tuning circuit 5.

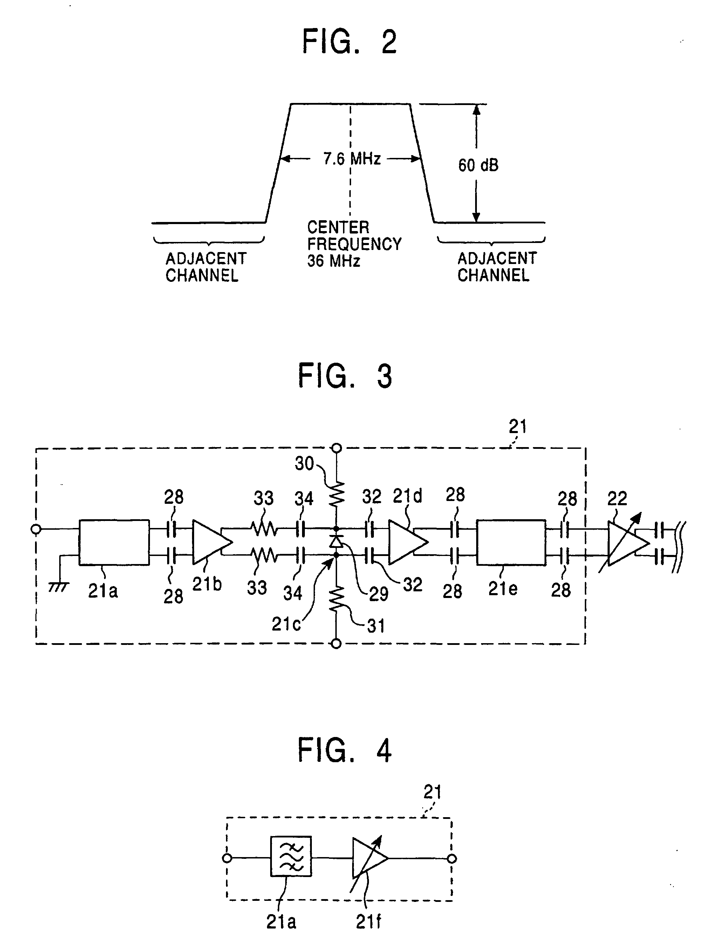

The intermediate frequency circuit 2 generates an 8-bit baseband signal from the first intermediate frequency signal obtained in the tuner 1. The intermediate frequency circuit 2 has adjacent-band attenuation means 21, a first variable-gain intermediate frequency amplifier 22, a second mixer 23, a second local oscillator 24, a second intermediate frequency amplifier 25, an analog-to-digital (A/D) converter 26, and a clock oscillator 27. The adjacent-band attenuation means 21 possesses characteristics in which the frequency bands of the adjacent channels are attenuated by 60 dB or greater, as illustrated in Fig. 2, assuming that the channel of the first intermediate frequency signal, which is a digital television signal to be received, is located adjacent to channels of analog television signals. By virtue of the above-mentioned characteristics, even if the level of a digital television signal at the tuner input terminal 1a is lower than the levels of the adjacent analog television signals by 35 dB, the level of the digital television signal at the input terminal of the second mixer 23 becomes higher than the adjacent analog television signals by 25 dB.

The first intermediate frequency signal output from the adjacent-band attenuation means 21 is amplified in the first intermediate frequency amplifier 22 and is then input into the second mixer 23. In the second mixer 23, the first intermediate frequency signal is mixed with a local oscillation signal output from the second local oscillator 24 and is converted into a second intermediate frequency signal of approximately 4 MHz. To stabilize the frequency, the second local oscillator 24 is provided with a crystal oscillator portion 24a. The second intermediate frequency signal is amplified in the second intermediate frequency amplifier 25 to a predetermined level and is input into the A/D converter 26. In the A/D converter 26, the second intermediate frequency signal is sampled by a clock signal having approximately 18 MHz output from the clock oscillator 27, thereby generating an 8-bit baseband signal. The baseband signal is demodulated and decoded in a baseband processing circuit (not shown) to extract a video signal and an audio signal. Because of the QPSK demodulation in the baseband processing circuit, not only a clock signal of 18 MHz, but also a clock signal of 36 MHz are output from the clock oscillator 27.

The configuration of the adjacent-band attenuation means 21 is discussed in detail with reference to Fig. 3. The adjacent-band attenuation means 21 is formed of a first surface acoustic wave (SAW) filter 21a, a first compensation amplifier 21b, a variable attenuator 21c, a second compensation amplifier 21d, and a second SAW filter 21e, and these elements are sequentially connected. The attenuation means 21 from the output terminal of the first SAW filter 21a to the output terminal of the second SAW filter 21e is formed of a balanced circuit.

The first SAW filter 21a and the second SAW filter 21e have substantially similar characteristics, and the respective filters 21a and 21e attenuate the frequency bands of the adjacent channels by substantially 30 dB or greater. The first compensation amplifier 21b and the second compensation amplifier 21d compensate for insertion losses incurred in the transmission bands of the first SAW filter 21a and the second SAW filter 21e, respectively. In this manner, the first SAW filter 21a is disposed at a stage before the first compensation amplifier 21b, thereby reducing the generation of distortion in the first compensation amplifier 21b. The second compensation amplifier 21d is disposed at a stage before the second SAW filter 21e, thereby suppressing the noise frequency (NF) caused by the second SAW filter 21e.

Direct-current (DC) blocking capacitors 28, 28 connect the first SAW filter 21a and the first compensation amplifier 21b, the second compensation amplifier 21d and the second SAW filter 21e, and the second SAW filter 21e and the second intermediate frequency amplifier 22. The variable attenuator 21c is provided with a PIN diode 29, which is connected in such a manner that it shunts two balanced lines. A fixed voltage (for example, a power supply voltage of 5V) is applied to the cathode via a bias resistor 30, while a control voltage output from a gain control voltage generating circuit (not shown) is supplied to the anode via a resistor 31. The PIN diode 29 and the second compensation amplifier 21d are connected via DC blocking capacitors 32, 32. The PIN diode 29 and the first compensation amplifier 21b are connected via impedance matching resistors 33, 33 and DC blocking capacitors 34, 34, which are respectively connected in series to each other.

Upon supplying a control voltage to the anode of the PIN diode 29, the adjacent-band attenuation means 21 is able to perform control in cooperation with the high frequency amplifier 4 of the tuner 1 and the first intermediate frequency amplifier 22 so that the level of an input digital television signal can be maintained at a dynamic range of approximately 76 dB.

If the bands of the adjacent channels are adequately attenuated by approximately 60 dB or greater only by the first SAW filter 21a, the second compensation amplifier 21d and the second SAW filter 21e may be omitted. The first compensation amplifier 21b and the variable attenuator 21c may be substituted with a second variable-gain amplifier 21f, and the first SAW filter 21a and the second variable-gain amplifier 21f may form the adjacent-band attenuation means 21, as illustrated in Fig. 4.

As is seen from the foregoing description, the digital television signal receiving tuner system of the present invention offers the following advantages.

The adjacent-band attenuation means is interposed between the first mixer and the second mixer to attenuate signals of the channels adjacent to the frequency band of a first intermediate signal by 60 dB or greater relative to the first intermediate frequency signal. Thus, in the second mixer, the interference of analog television signals of the adjacent channels is reduced. Since the adjacent-band attenuation means is disposed at a stage after the first mixer, known elements for receiving analog television signals can be used for the first mixer and the preceding elements, thereby simplifying the design of the digital television signal receiving tuner system.

Signals of the adjacent channels are attenuated by using the first and second SAW filters, and insertion losses caused by the first and second SAW filters are compensated with the first and second compensation amplifiers, respectively, thereby ensuring the intensity of the first intermediate frequency signal. The first compensation amplifier is disposed at a stage after the first SAW filter, thereby reducing distortion generated in the first compensation amplifier caused by analog television signals in the adjacent channels.

The first variable-gain amplifier is located at a stage before the first mixer, and the variable attenuator is placed at a stage after the first compensation amplifier, thereby increasing the dynamic range of receiving signals.

In place of the first compensation amplifier and the variable attenuator, a second variable-gain amplifier may be used, thereby simplifying the circuit.

## Claims

1. A digital television signal receiving tuner system comprising:
a first mixer (6) for converting a television signal to a first intermediate frequency signal;
an adjacent-band attenuation means (21) for attenuating a signal of a channel located adjacent to a frequency band of the first intermediate frequency signal by 60 dB or greater relative to the first intermediate frequency signal, said adjacent-band attenuation means being disposed at a stage after said first mixer; and
a second mixer (23) for converting the first intermediate frequency signal into a second intermediate frequency signal having a frequency lower than the frequency of the first intermediate frequency signal, said second mixer being disposed at a stage after said adjacent-band attenuation means; **characterised in that**
the adjacent-band attenuation means comprises a first surface acoustic wave filter (21a) for attenuating the signal of the adjacent channel, and a first compensation amplifier (21b) disposed at a stage after said first surface acoustic wave filter and compensates for insertion losses caused by said surface acoustic wave filter, and wherein the tuner system includes a first variable-gain amplifier (4) disposed at a stage before said first mixer, and said adjacent-band attenuation means further comprises a variable attenuator (21c) provided with a PIN diode (29).

2. A digital television signal receiving tuner system according to Claim 1, wherein said adjacent-band attenuation means comprises a second surface acoustic wave filter (21e) and a second compensation amplifier (21d) for correcting for insertion loss of said second surface acoustic wave filter at a stage after said first compensation amplifier, and said second compensation amplifier is connected at a stage before said second surface acoustic wave filter.

3. A digital television signal receiving tuner system according to Claim 2, wherein said variable attenuator is disposed between said first compensation amplifier and said second compensation amplifier.

4. A digital television signal receiving tuner system according to any of Claims 1 to 3, wherein said system further comprises a second variable-gain amplifier (22), and said first surface acoustic wave filter attenuates the band of the adjacent channel, and said second variable-gain amplifier is connected at a stage after said first surface acoustic wave filter so as to correct for insertion loss of said first surface acoustic wave filter.

5. A digital television signal receiving tuner system according to Claim 1, wherein said adjacent-band attenuation means comprises a second surface acoustic wave filter and a second compensation amplifier for correcting for insertion loss of said second surface acoustic wave filter at a stage before said second variable-gain amplifier, and said second compensation amplifier is connected at a stage before said second surface acoustic wave filter.

6. A digital television signal receiving tuner system according to any preceding claim, wherein an intermediate frequency circuit comprises an analog-to-digital converter (26) for converting the second intermediate frequency signal into a digital signal, and a clock oscillator (27) for supplying a clock signal to said analog-to-digital converter, the second intermediate frequency signal is sampled with the clock signal so as to output a baseband signal from said analog-to-digital converter, and the baseband signal and the clock signal are output from said intermediate frequency circuit.

## Patentansprüche

1. Digitalfernsehsignal-Empfangstunersystem, umfassend:
einen ersten Mischer (6) zum Umwandeln eines Fernsehsignals in ein erstes Zwischenfrequenzsignal;
eine Nachbarkanal-Dämpfungseinrichtung (21) zum Dämpfen eines Signals eines Kanals, der benachbart zu einem Frequenzband des ersten Zwischenfrequenzsignals gelegen ist, um 60 dB oder mehr in Bezug auf das erste Zwischenfrequenzsignal, wobei die Nachbarband-Dämpfungseinrichtung sich an einer Stelle hinter dem ersten Mischer befindet; und
einen zweiten Mischer (23) zum Umwandeln des ersten Zwischenfrequenzsignals in ein zweites Zwischenfrequenzsignal mit einer Frequenz, die niedriger ist als die Frequenz des ersten Zwischenfrequenzsignals, wobei der zweite Mischer sich an einer Stelle hinter der Nachbarband-Dämpfungseinrichtung befindet;
**dadurch gekennzeichnet, dass**
die Nachbarband―Dämpfungseinrichtung aufweist: ein erstes SAW-Filter (akustisches Oberflächenfilter) (21a) zum Dämpfen des Signals des Nachbarkanals, und einen ersten Kompensationsverstärker (21b), der an einer Stelle hinter dem ersten SAW-Filter angeordnet ist und von dem SAW-Filter verursachte Einfügungsverluste kompensiert, und dass das Tunersystem einen ersten Verstärker (4) mit variabler Verstärkung aufweist, der an einer Stelle vor dem ersten Mischer gelegen ist, und die Nachbarband-Dämpfungseinrichtung außerdem ein variables Dämpfungsglied (21c) aufweist, das mit einer PIN-Diode (29) ausgestattet ist.

2. Tunersystem nach Anspruch 1, bei dem die Nachbarband―Dämpfungseinrichtung ein zweites SAW-Filter (21e) und einen zweiten Kompensationsverstärker (21d) zum Korrigieren des von dem zweiten SAW-Filter hervorgerufenen Einfügungsverlusts an einer Stelle hinter dem ersten Kompensationsverstärker aufweist, und der zweite Kompensationsverstärker an einer Stelle vor dem zweiten SAW-Filter angeschlossen ist.

3. Tunersystem nach Anspruch 2, bei dem das variable Dämpfungsglied sich zwischen dem ersten und dem zweiten Kompensationsverstärker befindet.

4. Tunersystem nach einem der Ansprüche 1 bis 3, bei dem das System außerdem einen zweiten Verstärker (22) mit veränderlicher Verstärkung aufweist, und das erste SAW-Filter das Band des Nachbarkanals dämpft, und der zweite Verstärker mit veränderlicher Verstärkung an einer Stelle hinter dem ersten SAW-Filter angeschlossen ist, um die Einfügungsdämpfung des ersten SAW-Filters zu korrigieren.

5. Tunersystem nach Anspruch 1, bei dem die Nachbarband-Dämpfungseinrichtung ein zweites SAW-Filter und einem zweiten Kompensationsverstärker zum Korrigieren der von dem zweiten SAW-Filter hervorgerufenen Einfügungsdämpfung an einer Stelle vor dem zweiten Verstärker veränderlicher Verstärkung aufweist, und der zweite Kompensationsverstärker an einer Stelle vor dem zweiten SAW-Filter angeschlossen ist.

6. Tunersystem nach einem der vorhergehenden Ansprüche, bei dem eine Zwischenfrequenzschaltung einen Analog-Digital-Wandler (26) zum Umwandeln des zweiten Zwischenfrequenzsignals in ein digitales Signal aufweist, außerem einen Taktoszillator (27) zum Liefern eines Taktsignals an den Analog-Digital-Wandler, wobei das zweite Zwischenfrequenzsignal mit dem Taktsignal abgetastet wird, um ein Basisbandsignal aus dem Analog-Digital-Wandler auszugeben, wobei das Basisbandsignal und das Taktsignal von der Zwischenfrequenzschaltung ausgegeben werden.

## Revendications

1. Système de syntoniseur recevant des signaux de télévision numériques, comprenant :
un premier mélangeur (6) permettant de convertir un signal de télévision en un premier signal de fréquence intermédiaire ;
une moyen d'atténuation de bande adjacente (21) permettant d'atténuer un signal d'un canal situé au voisinage d'une bande de fréquence du premier signal de fréquence intermédiaire de 60 dB ou plus par rapport au premier signal de fréquence intermédiaire, ledit moyen d'atténuation de bande adjacente étant disposé à un étage suivant ledit premier mélangeur ; et
un deuxième mélangeur (23) permettant de convertir le premier signal de fréquence intermédiaire en un deuxième signal de fréquence intermédiaire ayant une fréquence inférieure à la fréquence du premier signal de fréquence intermédiaire, ledit deuxième mélangeur étant disposé à un étage suivant ledit moyen d'atténuation de bande adjacente ; **caractérisé en ce que** :
le moyen d'atténuation de bande adjacente comprend un premier filtre d'ondes acoustiques superficielles (21a) permettant d'atténuer le signal du canal adjacent, et un premier amplificateur à compensation (21b) disposé à un étage suivant ledit premier filtre d'ondes acoustiques superficielles, et compense les pertes d'insertion provoquées par ledit filtre d'ondes acoustiques superficielles, et dans lequel le système de syntoniseur inclut un premier amplificateur à gain variable (4) disposé à un étage précédant ledit premier mélangeur, et ledit moyen d'atténuation de bande adjacente comprend en outre un atténuateur variable (21c) doté d'une diode PIN (29).

2. Système de syntoniseur recevant des signaux de télévision numériques selon la revendication 1, dans lequel ledit moyen d'atténuation de bande adjacente comprend un deuxième filtre d'ondes acoustiques superficielles (21e), et un deuxième amplificateur à compensation (21d) permettant de corriger une perte d'insertion dudit deuxième filtre d'ondes acoustiques superficielles à un étage suivant ledit premier amplificateur à compensation, et ledit deuxième amplificateur à compensation est connecté à un étage précédant ledit deuxième filtre d'ondes acoustiques superficielles.

3. Système de syntoniseur recevant des signaux de télévision numériques selon la revendication 2, dans lequel ledit atténuateur variable est disposé entre ledit premier amplificateur à compensation et ledit deuxième amplificateur à compensation.

4. Système de syntoniseur recevant des signaux de télévision numériques selon l'une quelconque des revendications 1 à 3, dans lequel ledit système comprend en outre un deuxième amplificateur à gain variable (22), et ledit premier filtre d'ondes acoustiques superficielles atténue la bande du canal adjacent, et le deuxième amplificateur à gain variable est connecté à un étage suivant ledit premier filtre d'ondes acoustiques superficielles de manière à corriger la parte d'insertion du premier filtre d'ondes acoustiques superficielles.

5. Système de syntoniseur recevant des signaux de télévision numériques selon la revendication 1, dans lequel ledit moyen d'atténuation de bande adjacente comprend un deuxième filtre d'ondes acoustiques superficielles et un deuxième amplificateur à compensation permettant de corriger la perte d'insertion dudit deuxième filtre d'ondes acoustiques superficielles à un étage précédant ledit deuxième amplificateur à gain variable, et ledit deuxième amplificateur à compensation est connecté à un étage précédant ledit deuxième filtre d'ondes acoustiques superficielles.

6. Système de syntoniseur recevant des signaux de télévision numériques selon l'une quelconque des revendications précédentes, dans lequel un circuit de fréquence intermédiaire comprend un convertisseur analogique / numérique (26) permettant de convertir le deuxième signal de fréquence intermédiaire en signal numérique, et un oscillateur d'horloge (27) permettant de délivrer un signal d'horloge audit convertisseur analogique / numérique, le deuxième signal de fréquence intermédiaire étant échantillonné avec le signal d'horloge de manière à faire sortir un signal de bande de base dudit convertisseur analogique / numérique, et le signal de bande de base et le signal d'horloge sortant dudit circuit de fréquence intermédiaire.
